Europäisches Patentamt

European Patent Office

Office européen des brevets

(19)

(11) Veröffentlichungsnummer : **0 105 151**
**B1**

(12) **EUROPÄISCHE PATENTSCHRIFT**

(45) Veröffentlichungstag der Patentschrift :
29.07.87

(51) Int. Cl.⁴ : **H 05 K   7/14**

(21) Anmeldenummer : **83108100.5**

(22) Anmeldetag : **17.08.83**

(54) **Baugruppeneinheit.**

(30) Priorität : **30.09.82 CH 5777/82**

(43) Veröffentlichungstag der Anmeldung :
**11.04.84 Patentblatt 84/15**

(45) Bekanntmachung des Hinweises auf die Patenterteilung : **29.07.87 Patentblatt 87/31**

(84) Benannte Vertragsstaaten :
**AT BE CH DE FR GB IT LI NL SE**

(56) Entgegenhaltungen :
**DE-A- 2 119 709**
**DE-A- 2 556 225**
**DE-B- 1 197 151**
**US-A- 3 347 608**
**US-A- 3 699 396**
**US-A- 3 939 382**

(73) Patentinhaber : **CONTRAVES AG**
**Schaffhauserstrasse 580**
**CH-8052 Zürich (CH)**

(72) Erfinder : **Hänseler, Urs**
**Rütistrasse 10**
**CH-8122 Pfaffhausen (CH)**
Erfinder : **Meier, Urs**
**Hubring 44**
**CH-8303 Bassersdorf (CH)**
Erfinder : **Muther, Franz**
**Nordstrasse 408**
**CH-8037 (CH)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

## Beschreibung

Die Erfindung bezieht sich auf eine Baugruppeneinheit, bestehend aus einem Traggestell mit zwei Seitenwänden, zwei vorderen und zwei hinteren Tragleisten und mindestens einer Führungseinheit mit einem Paar an den Tragleisten steckbar befestigten Führungsschienen sowie einem durch mindestens ein Halteglied im Traggestell gehaltenen Baugruppenträger, welcher mit einem Stiften-Steckerelement zur gegenseitigen elektrischen Verbindung mit einem an den hinteren Tragleisten angeordneten Buchsen-Steckerelement versehen ist.

Aus der DE-B 20 07 303 ist eine Baugruppeneinheit mit entsprechend ausgebildetem Traggestell der vorerwähnten Art bekannt, bei welcher Baugruppeneinheit zur Befestigung im Abstand zueinander angeordneter Buchsen-Steckerelemente an den hinteren Tragleisten eine Vielzahl in Abständen zueinander angeordnete Gewindebohrungen vorgesehen sind. Die zur elektrischen Verbindung mit einschiebbaren Baugruppenträgern vorgesehenen Buchsen-Steckerelemente sind mit Schrauben an den Tragleisten befestigt, wobei die Schrauben gleichzeitig auch zur Befestigung der hinteren Enden der unteren und oberen Führungsschienen an den Tragleisten dienen. Im vorderen Bereich sind die Führungsschienen mit Nasen versehen, welche in entsprechend ausgebildete Durchbrüche eines oberen und unteren, zusätzlichen Metallstreifens einschnappen. Die Herstellung der Gewindebohrungen in den Tragleisten erfordert einen grossen Aufwand für die erforderliche Genauigkeit und für die Montage und Befestigung der Buchsen-Steckerelemente einen grossen Aufwand an Arbeitszeit.

Soll beispielsweise ein Buchsen-Steckerelement ausgewechselt werden, so ist es bei dem bekannten Traggestell erforderlich, die entsprechenden Schrauben zu lösen und zu entfernen. Auch kann es bei dieser Baugruppeneinheit leicht geschehen, dass sich im Betrieb durch ständige Vibration eine Schraube selbsttätig löst und zwischen die anderen Baugruppenträger fällt und einen Kurzschluss verursacht oder aber verloren geht.

Bei einem Rahmen zur Aufnahme von in Führungsschienen eingeschobenen Schaltungen ist es aus der US-A 3 939 382 bekannt, dass die Führungsschienen zur Halterung eines Steckteils an dem einen Ende je mit einem Zapfen versehen sind.

Aus der DE-A 25 56 225 ist ferner ein mit Einkerbungen versehenes Verbindungsteil für gedruckte Schaltungskarten bekannt, in welche nutartigen Einkerbungen in zusammengebautem Zustand nasenartig ausgebildete, an Griffleisten angeordnete Vorsprünge eingreifen und zusätzlich durch Schraubverbindungen gesichert sind.

Der Erfindung liegt die Aufgabe zugrunde, einerseits eine konstruktiv sowie in der Herstellung einfache, schraubenlose Montage und Befestigung der Führungsschienen und der Buchsen-Steckerelemente an den Tragleisten vorzusehen und andererseits mit einfachen Mitteln und ohne besonderen Aufwand die mit Trägerelementen versehenen, in das Traggestell eingeschobenen Baugruppenträger rüttelsicher und mit dem Traggestell eine stabile Einheit bildend anzuordnen.

Erfindungsgemäss wird diese Aufgabe dadurch gelöst, dass

a) die jeweils mit dem vorderen und hinteren Ende steckbar an den Tragleisten befestigten Führungsschienen zur Halterung des Buchsen-Steckerelements am hinteren Ende je ein in entsprechend am Buchsen-Steckerelement vorgesehene Ausnehmungen einführbares Halteorgan mit Zapfen aufweisen,

b) zur Stabilisierung der Baugruppeneinheit am oberen und unteren Teilstück der Trägerelemente je eine Nase angeordnet ist, die in eingeschobenem Zustand des Baugruppenträgers mit einer entsprechend in den vorderen Tragleisten angeordneten Nut im Eingriff stehen, und

c) das zur Halterung der einzelnen Baugruppenträger vorgesehene Halteglied an der der Stirnseite des Trägerelements zugewandten Seite mit stosselastischen Profilteilen versehen ist.

Bei einer Baugruppeneinheit mit einem Traggestell, welches zur Aufnahme und gegenseitigen elektrischen Verbindung zweistöckig ausgebildeter und mit zwei Stiften-Steckerelementen versehener Baugruppenträger zwischen den beiden hinteren Tragleisten eine dritte Tragleiste aufweist, ist nach einem weiteren Merkmal der Erfindung zur Halterung von zwei den Stiften-Steckerelementen entsprechend zugeordneten Buchsen-Steckerelementen ein mit der dritten Tragleiste einrastend in Eingriff bringbarer Steckerhalter vorgesehen.

Weitere Merkmale der Erfindung ergeben sich aus der folgenden Beschreibung in Verbindung mit der Zeichnung und den Patentansprüchen.

Die Erfindung wird anhand von Zeichnungen beschrieben. In den Zeichnungen zeigt:

Figur 1 ein in perspektivischer Vorderansicht dargestelltes Traggestell in zweistöckiger Ausführung mit zugehörigem, herausgezogenen Baugruppenträger für elektronische Elemente,

Figur 2 das Traggestell gemäss Fig. 1 in einstöckiger Ausführung mit entsprechend einstöckig ausgebildetem, herausgezogenen Bautruppenträger,

Figur 3 eine in grösserem Massstab, perspektivisch dargestellte Schnittansicht der Stirnseite des Traggestell- und Baugruppenträger-Aufbausystems in demontiertem Zustand,

Figur 4 eine in grösserem Massstab, perspektivisch dargestellte Schnittansicht der Rückseite des Traggestell- und Baugruppenträger-Aufbausystems in demontiertem Zustand,

Figur 5 einen in Vorderansicht dargestellten Steckerhalter für in dem Traggestell zu befestigende Buchsen-Steckerelemente,

Figur 6 den Steckerhalter gemäss Fig. 5 in Stirnansicht, und

Figur 7 den Steckerhalter in Draufsicht.

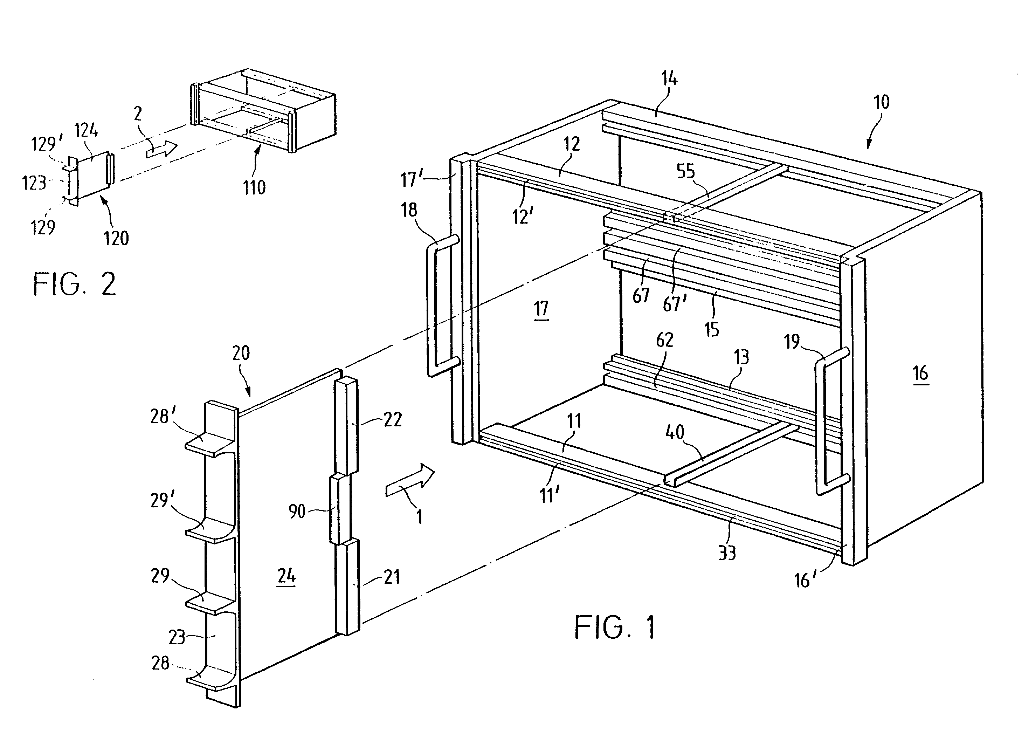

In Fig. 1 ist mit 10 ein schematisch dargestelltes Traggestell bezeichnet, welches zur Aufnahme und Befestigung sowie gegenseitigen elektrischen Verbindung als zweistöckig ausgebildeter Baugruppenträger 20 ausgebildet ist.

Das Traggestell 10 weist an seiner Stirnseite eine untere und eine obere Tragleiste 11 und 12 sowie an seiner Rückseite eine untere und eine obere Tragleiste 13 und 14 auf. An der weitgehend offenen Rückseite ist bei dem Traggestell 10 nach Fig. 1 zwischen den beiden hinteren Tragleisten 13, 14 zusätzlich eine mittlere Tragleiste 15 angeordnet. Die Tragleisten 11, 12, 13, 14 und 15 sind mit nicht dargestellten Mitteln an entsprechend zugeordneten Seitenwänden 16, 17 befestigt. Die Teile 11, 12, 13, 14, 15, 16 und 17 bilden zusammen eine stabile, kastenartig ausgebildete Baueinheit.

An der Stirnseite des Traggestells 10 ist an den beiden Seitenwänden 16, 17 je ein mit nicht dargestellten Mitteln befestigter Griff 18, 19 vorgesehen.

Als Einführhilfe und zur Halterung der einzelnen Baugruppenträger sind in fertig montiertem Zustand des Traggestells 10 an den oberen und unteren Tragleisten 11, 12, 13 und 14 nebeneinander angeordnete Führungsschienen vorgesehen. In Fig. 1 ist zur besseren Uebersicht lediglich ein korrespondierendes Führungsschienenpaar 40, 55 für den in Pfeilrichtung 1 in das Traggestell 10 einschiebbaren Baugruppenträger 20 dargestellt.

Der Baugruppenträger 20, der nach der Darstellung in Fig. 1 noch nicht in das Traggestell 10 eingeschoben ist, umfasst eine Leiterplatte 24, ein erstes und ein zweites an der Schmalseite der Leiterplatte 24 angeordnetes und mit nicht dargestellten Stiften versehenes Stiften-Steckerelement 21, 22 sowie ein an der Stirnseite der Leiterplatte 24 angeordnetes und in Fig. 1 mit nicht näher dargestellten Mitteln befestigtes, leistenartig ausgebildetes Trägerelement 23. Die Leiterplatte 24 dient zur Aufnahme und elektrischen Verbindung nicht dargestellter elektronischer Elemente.

Fig. 2 zeigt als Variante ein Traggestell 110, welches zur Aufnahme und gegenseitigen elektrischen Verbindung einstöckig ausgebildeter und in Pfeilrichtung 2 in das Traggestell 110 einschiebbarer Baugruppenträger 120 ausgebildet ist. Der konstruktive Aufbau des Traggestells 110 sowie des die Teile 123, 124, 129, 129' umfassenden Baugruppenträgers 120 entspricht im wesentlichen dem Traggestell 10 gemäss Fig. 1, wobei bei der Variante nach Fig. 2 lediglich die Höhe des Baugruppenträgers und des Traggestells kleiner und dadurch die zusätzliche mittlere Tragleiste 15 an der Rückseite nicht erforderlich ist.

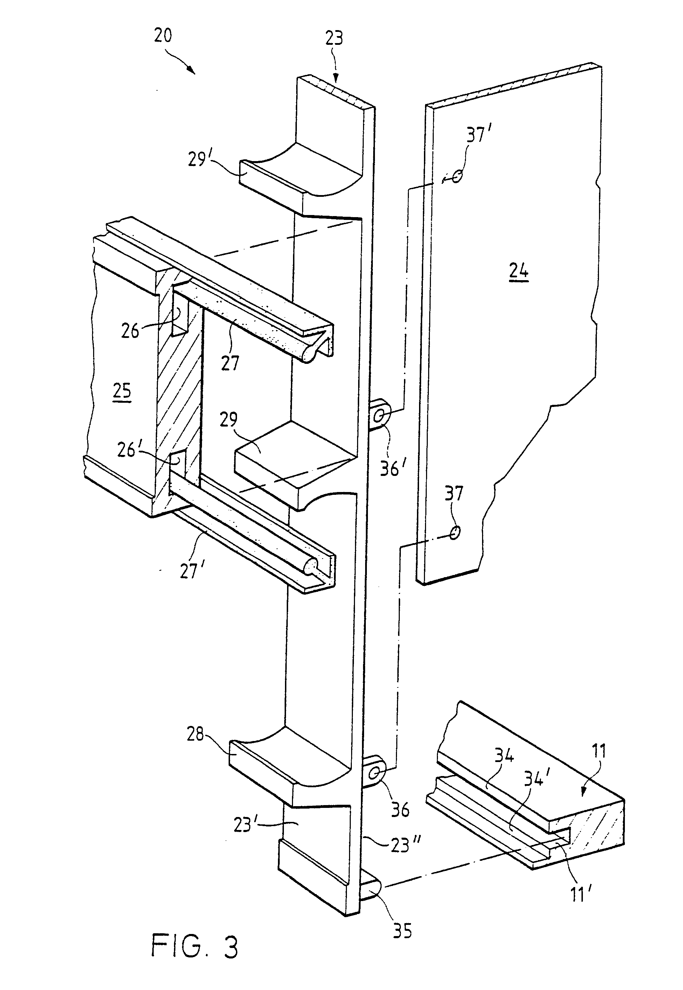

In Fig. 3 ist in grösserem Massstab eine perspektivische Schnittansicht des Stirnseiten-Aufbausystems mit dem in demontiertem Zustand dargestellten Baugruppenträger 20 und der unteren Tragleiste 11 des Traggestells 10 dargestellt. Die Tragleiste 11 weist auf der dem Trägerelement 23 zugewandten Seite zwei miteinander korrespondierende Anlageflächen 34, 34' sowie eine in Längsrichtung orientierte Nut 11' auf. Die obere, in Fig. 3 nicht dargestellte Tragleiste 12 des Traggestells 10 gemäss Fig. 1 ist analog der unteren Tragleiste 11 ausgebildet und mit einer Nut 12' versehen.

Weiterhin erkennt man in Fig. 3 die Leiterplatte 24 des Baugruppenträgers 20. Die Leiterplatte 24 ist mit im Abstand zueinander angeordneten Löchern 37, 37' versehen und wird mit nicht dargestellten Befestigungsmitteln an den im Abstand zueinander angeordneten Ansätzen 36, 36' des Trägerelements 23 befestigt. Die Teile 21, 22, 23 und 24 bilden den als eine Baueinheit (Fig. 1) ausgebildeten Baugruppenträger 20, welcher mittels an der Stirnseite 23' des Trägerelements 23 angeordneten Handgriffen 28, 28', 29, 29', wie in Fig. 1 mit Pfeilrichtung 1 dargestellt, in das Traggestell 10 einschiebbar ist. In eingeschobenem Zustand des einzelnen Baugruppenträgers 20 ist die Leiterplatte 24 in den Führungsschienen 40, 55 geführt, wobei das Trägerelement 23 im unteren Bereich mit der Rückseite 23" an den Anlageflächen 34, 34' der Tragleiste 11 und im oberen Bereich an nicht dargestellten und nicht näher bezeichneten Anlageflächen der Tragleiste 12 fest anliegt. Zur Erreichung einer optimalen Positionierung und Stabilität wird das Trägerelement 23 mit einer an der Rückseite 23" angeordneten Nase 35 in die Nut 11' der Tragleiste 11 eingeschoben, wobei im oberen Bereich des Trägerelements 23 ebenfalls eine Nase (nicht dargestellt) vorgesehen ist, welche in die entsprechende Nut 12' der oberen Tragleiste 12 eingreift.

Zur Verriegelung der einzelnen in das Traggestell 10 eingeschobenen Baugruppenträger 20 ist ein schienenartig ausgebildetes Halteglied 25 vorgesehen. Das Halteglied 25 weist zur stosselastischen Halterung auf der dem Trägerelement 23 zugewandten Seite zwei in Nuten 26, 26' eingesetzte und gehaltene sowie in Längsrichtung des Halteglieds 25 orientierte, gummielastische Profilteile 27, 27' auf. Das gemäss der in Fig. 3 strichpunktierten Linien mit den beiden Profilteilen 27, 27' zwischen die beiden Handgriffe 29, 29' einsetzbare Halteglied 25 reicht über die gesamte Breite des Traggestells 10 (nicht dargestellt) und ist mit nicht dargestellten Mitteln an den Stirnseiten 16', 17' der Traggestell-Seitenwände 16, 17 lösbar befestigt. Das mit den Profilteilen 27, 27' versehene Halteglied 25 gewährleistet eine stosselastische, militärtaugliche Halterung der Baugruppenträger 20, 120 in dem Traggestell 10, 110.

An dieser Stelle sei darauf hingewiesen, dass bei dem einstöckig ausgebildeten Traggestell 110 gemäss Fig. 2 das Trägerelement 123 des Baugruppenträgers 120 nur zwei Handgriffe 129, 129' aufweist, zwischen welchen ein entsprechend dem Halteglied 25 ausgebildetes, nicht näher dargestelltes Halteglied für die Halterung der einzelnen Baugruppenträger 120 einsetzbar ist.

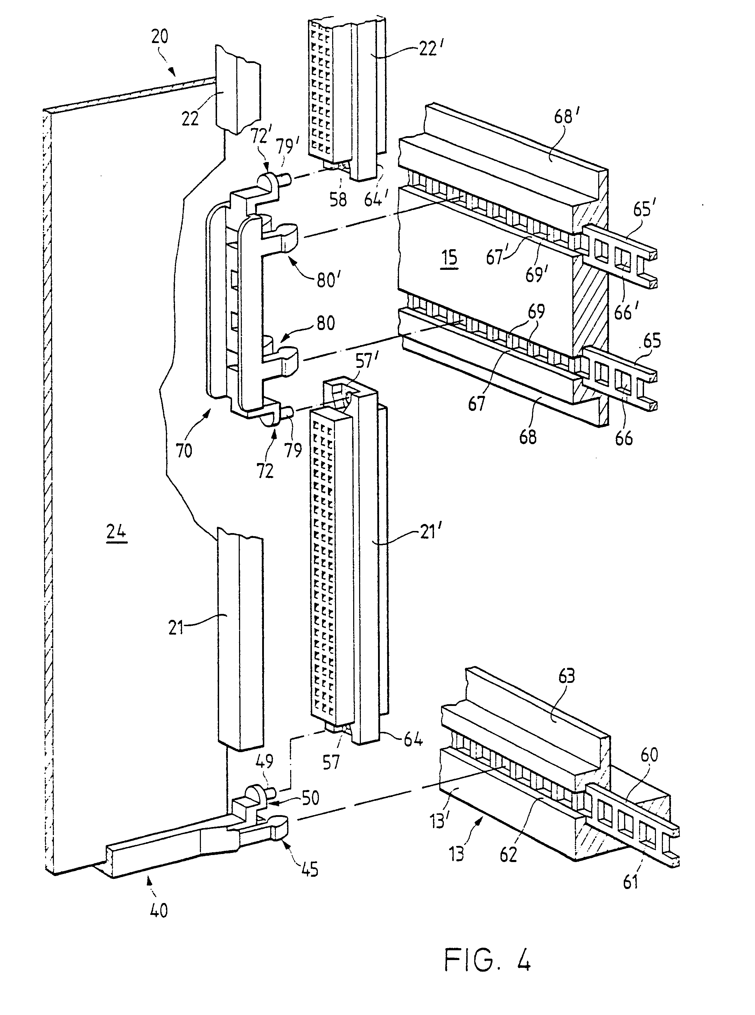

In Fig. 4 ist in grösserem Massstab eine perspektivische Schnittansicht des Rückseiten-Aufbausystems mit dem in demontiertem Zustand dargestellten Baugruppenträger 20 dargestellt und man erkennt die Leiterplatte 24, die Führungsschiene 40, ein Teilstück der Stiften-Steckerelemente 21, 22 sowie die hintere, untere Tragleiste 13 des Traggestells 10. Die Tragleiste 13 weist auf der dem Baugruppenträger 20 zugewandten Stirnseite 13' eine in Längsrichtung orientierte Aussparung 62 und versetzt zu der Stirnseite 13' eine Anlagefläche 63 auf. In die Aussparung 62 ist ein durch die Formgebung der Aussparung gegen Herausfallen gesicherter Blechstreifen 60 eingeschoben, welcher mit einer Vielzahl, im Abstand zueinander angeordneter Ausnehmungen 61 versehen ist, welche den Blechstreifen durchdringen.

Die obere, in Fig. 4 nicht dargestellte Tragleiste 14 des Traggestells 10 gemäss Fig. 1 ist analog der unteren Tragleiste 13 ausgebildet und weist ebenfalls einen mit Ausnehmungen versehenen, korrespondierend zu dem Blechstreifen 60 angeordneten und nicht näher bezeichneten Blechstreifen auf.

Weiterhin erkennt man in Fig. 4 die im Abstand zu der unteren Tragleiste 13 angeordnete mittlere Tragleiste 15 sowie zwei Buchsen-Steckerelemente 21', 22', welche korrespondierend zu den an der Leiterplatte 24 des Baugruppenträgers 20 befestigten Stiften-Steckerelementen 21, 22 angeordnet sind. Die Buchsen-Steckerelemente 21', 22' werden einerseits in zusammengebautem Zustand mittels eines Zapfens 49 von am hinteren Ende der oberen und unteren Führungsschiene 40, 55 angeordneter und in Fig. 4 schematisch dargestellter Halteorgane 50 an der oberen und unteren hinteren Tragleiste 13, 14 und andererseits mittels einem zusätzlichen Steckerhalter 70 an der mittleren Tragleiste 15 gehalten.

Die zwischen der unteren und der oberen Tragleiste 13, 14 angeordnete mittlere Tragleiste 15 ist auf der dem Baugruppenträger 20 zugewandten Seite mit zwei im Abstand zueinander angeordneten und in Längsrichtung der Tragleiste orientierten Aussparungen 67, 67' sowie mit zwei, einer oberen und einer unteren, Anlageflächen 68, 68' versehen. In die beiden Aussparungen 67, 67' ist je ein gegen Herausfallen gesicherter Blechstreifen 65, 65' eingeschoben, welche je mit einer Vielzahl im Abstand zueinander angeordneter und durch Stege 69, 69' voneinander getrennter Ausnehmungen 66, 66' versehen sind.

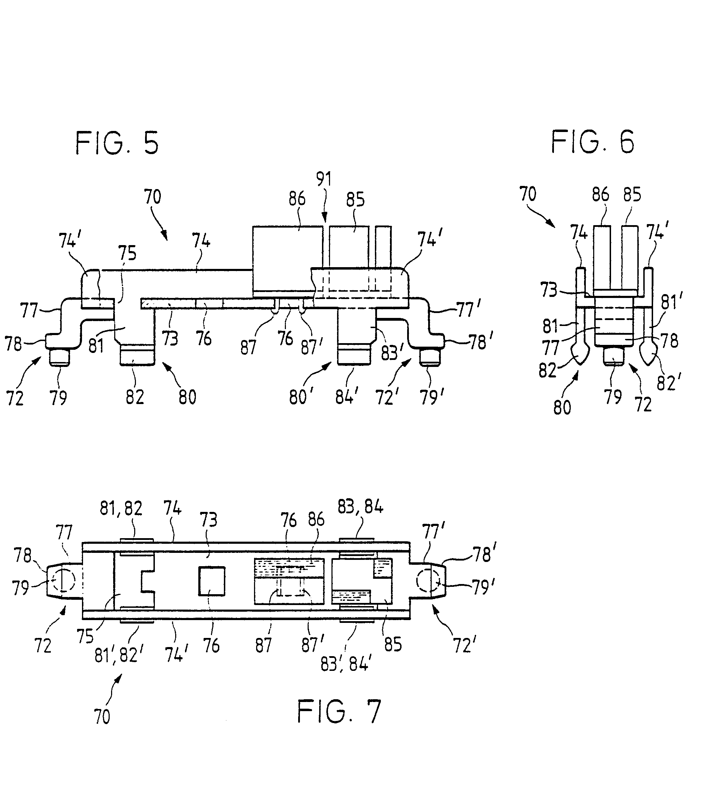

In den Figuren 5, 6 und 7 ist der Steckerhalter 70 dargestellt, welcher nachstehend näher beschrieben wird.

Fig. 5 zeigt eine teilweise im Schnitt dargestellte Vorderansicht des Steckerhalters 70, welcher im wesentlichen einen aus Seitenwänden 74, 74' und einem Boden 73 gebildeten U-förmigen Profilquerschnitt aufweist. An beiden Enden des Steckerhalters 70 ist an dem Boden 73 je ein nach unten abgewinkeltes Halteorgan 72, 72' und zwischen den beiden Halteorganen zwei im Abstand zueinander angeordnete, nach unten abgewinkelte Rasterorgane 80, 80' angeformt. In dem Boden 73 sind ferner im Abstand zueinander angeordnete und den Boden durchdringende Ausnehmungen 75, 76 vorgesehen, die zur Aufnahme von Codierteilen dienen. In Fig. 5 sind als Beispiel nur zwei Codierteile 85, 86 schematisch dargestellt, welche mittels federnd in die Ausnehmungen 75, 76 einrastender und an der Unterseite des Bodens 73 angreifender Rasterzapfen 87, 87' gehalten sind.

Das als Fortsetzung am Boden 73 angeformte, erste Halteorgan 72 umfasst einen Zapfen 79, einen in parallelem Abstand zum Boden 73 angeordneten ersten Steg 73 sowie einen zweiten, am Boden 73 angeformten Steg 77. Das zweite Halteorgan 72' ist analog dem ersten Halteorgan 72 ausgebildet und umfasst die Teile 79', 78' und 77'. Das erste Rasterorgan 80 umfasst zwei an den Seitenwänden 74, 74' angeformte, quer zur Längsrichtung des Steckerhalters 70 federnd ausgebildete Schenkel 81, 81' sowie zwei an den Schenkeln 81, 81' angeformte Rasterzapfen 82, 82'. Das zweite Rasterorgan 80' ist analog dem ersten Rasterorgan 80 ausgebildet und umfasst die Teile 83, 83' und 84, 84'.

In Fig. 6 ist der aus den Seitenwänden 74, 74' und dem Boden 73 im Profilquerschnitt U-förmig ausgebildete Steckerhalter 70 in Stirnansicht dargestellt und man erkennt das aus den Teilen 79, 78 und 77 gebildete erste Halteorgan 72, das aus den Teilen 81, 81' und 82, 82' gebildete erste Rasterorgan 80 sowie die zwischen den Seitenwänden 74, 74' angeordneten und im Boden 73 eingerasteten Codierteile 85, 86.

In Fig. 7 ist der Steckerhalter 70 in Draufsicht dargestellt und man erkennt die im vorderen und hinteren Bereich angeordneten Halteorgane 72, 72', die Teile 81, 81', 82, 82', 83, 83' und 84, 84' der beiden Rasterorgane 80, 80', die im Abstand zueinander angeordneten Ausnehmungen 75, 76 sowie die beiden Codierteile 85, 86 eines zweiten Codierelements 91.

Nachstehend wird als Beispiel der Zusammenbau des zweistöckig ausgebildeten Aufbausystems beschrieben :

Ausgehend von dem in Fig. 1 dargestellten und aus den Teilen 11, 12, 13, 14, 15, 16 und 17 gebildeten Traggestell 10 werden zweckmässigerwei zunächst die beiden Buchsen-Steckerelemente 21', 22' in das Traggestell 10 eingebracht und im wesentlichen mit dem Steckerhalter 70 an der mittleren Tragleiste 15, mit der Führungsschiene 40 an der Tragleiste 13 sowie mittels der Führungsschiene 55 an der Tragleiste 14 lösbar befestigt.

Zur Halterung der beiden Buchsen-Steckerelemente 21', 22' wird, wie in Fig. 4 durch die strichpunktierten Linien dargestellt, erstens, der mit den Rasterorganen 80, 80' versehene Steckerhalter 70 mit den beiden Blechstreifen 65, 65' der Tragleiste 15, zweitens, mittels an der Führungsschiene 40 angeordneter, schematisch dargestellter Rasterorgane 45 mit dem Blechstreifen 60 der Tragleiste 13 und drittens, mittels dem nicht dargestellten Rasterorgan der oberen Führungsschiene 55 mit dem nicht dargestellten Blechstreifen der oberen Tragleiste 14 in Eingriff gebracht. Bei diesem Vorgang durchdringen die beiden Zapfen 79, 79″ der Halterorgane 72, 72′ die mit entsprechend ausgebildeten und zugeordneten Ausnehmungen 57′, 58 versehenen Buchsen-Steckerelemente 21′, 22′ und die tropfenförmig ausgebildeten Rasterzapfen 82, 82′ und 84, 84′ der Rasterorgane 80, 80′ werden in die Ausnehmungen 66, 66′ der Blechstreifen 65, 65′ eingedrückt. In der Endstellung sind die federnd ausgebildeten Rasterzapfen 82, 82′ und 84, 84′ in nicht näher dargestellter Weise hinter den Stegen 69, 69′ der Blechstreifen 65, 65′ eingerastet und die Buchsen-Steckerelemente 21′, 22′ werden mit ihren leistenartigen Ansätzen 64, 64′ fest anliegend gegen die Anlageflächen 68, 68′ der Tragleiste 15 gedrückt.

Die Befestigung der Buchsen-Steckerelemente 21′, 22′ im unteren und oberen Bereich des Traggestells 10 mittels der an den Führungsschienen 40, 55 angeordneten Rasterorgane 45 an den hinteren Tragleisten 13, 14 ist im wesentlichen analog der voran beschriebenen Befestigung des Steckerhalters 70 an der Tragleiste 15 ausgebildet. Zur Befestigung der beiden Führungsschienen 40, 55 an den vorderen Tragleisten 11 und 12 sind im vorderen Bereich der Führungsschienen entsprechend ausgebildete, nicht dargestellte Rasterorgane vorgesehen.

Als Einführhilfe zum Einschieben des Baugruppenträgers 20 in das Traggestell 10 ist in den Führungsschienen 40, 55 je eine nicht näher dargestellte Nut und in der Nut mindestens ein nicht dargestelltes Federelement zur Führung der Leiterplatte 24 vorgesehen. Die Nuten und Federelemente der Führungsschienen 40, 55 gewährleisten ein exaktes Zusammenfügen der Stiften- mit den Buchsen-Steckerelementen 21, 21′ und 22, 22′.

In Fig. 1 ist an dem Baugruppenträger 20 zwischen den beiden Stiften-Steckerelementen 21, 22 ein schematisch dargestelltes Codierelement 90 angeordnet und befestigt. In zusammengebautem Zustand steht das erste Codierelement 90 mit einem zweiten, nicht näher dargestellten Codierelement 91 in Wirkverbindung. Das zweite Codierelement 91 umfasst mehrere in dem Steckerhalter 70 eingesetzte und in Reihe angeordnete Codierteile 85, 86. Mit den beiden Codierelementen 90, 91 werden Fehleinschübe der mit unterschiedlichen Modulen versehenen Baugruppenträger und somit ein Zusammenfügen und Deformieren nicht zusammengehöriger Stiften-Buchsen-Steckerelemente vermieden.

**Patentansprüche**

1. Baugruppeneinheit, bestehend aus einem Traggestell (10, 110) mit zwei Seitenwänden (16, 17), zwei vorderen und zwei hinteren Tragleisten (11, 12 ; 13, 14) und mindestens einer Führungseinheit mit einem Paar an den Tragleisten steckbar befestigten Führungsschienen (40, 55) sowie einem durch mindestens ein Halteglied (25) im Traggestell (10, 110) gehaltenen Baugruppenträger (20, 120), welcher mit einem Stiften-Steckerelement (21) zur gegenseitigen elektrischen Verbindung mit einem an den hinteren Tragleisten (13, 14) angeordneten Buchsen-Steckerelement (21′) versehen ist, dadurch gekennzeichnet, dass

a) die jeweils mit dem vorderen und hinteren Ende steckbar an den Tragleisten (11, 12 ; 13, 14) befestigten Führungsschienen (40, 55) zur Halterung des Buchsen-Steckerelementes (21′) am hinteren Ende je ein in entsprechend am Buchsen-Steckerelement vorgesehene Ausnehmungen (57, 57′ ; 58, 58′) einführbares Halteorgan (50) mit Zapfen (49) aufweisen,

b) zur Stabilisierung der Baugruppeneinheit am oberen und unteren Teilstück der Trägerelemente (23) je eine Nase (35) angeordnet ist, die in eingeschobenem Zustand des Baugruppenträgers (20, 120) mit einer entsprechend in den vorderen Tragleisten (11, 12) angeordneten Nut (11′, 12′) im Eingriff stehen, und

c) das zur Halterung der einzelnen Baugruppenträger (20, 120) vorgesehene Halteglied (25) an der der Stirnseite (23′) des Trägerelements (23) zugewandten Seite mit stosselastischen Profilteilen (27, 27′) versehen ist.

2. Baugruppeneinheit mit dem Traggestell (10), welches zur Aufnahme und gegenseitigen elektrischen Verbindung zweistöckig ausgebildeter und mit Stiften-Steckerelementen (21, 22) versehener Baugruppenträger (20) zwischen den beiden hinteren Tragleisten (13, 14) eine dritte Tragleiste (15) aufweist, dadurch gekennzeichnet, dass zur Halterung von zwei den Stiften-Steckerelementen (21, 22) entsprechend zugeordneten Buchsen-Steckerelementen (21′, 22′) ein mit der dritten Tragleiste (15) einrastend in Eingriff bringbarer Steckerhalter (70) vorgesehen ist.

3. Baugruppeneinheit nach Anspruch 2, dadurch gekennzeichnet, dass der im Profil-Querschnitt U-förmige Steckerhalter (70) an beiden Enden nach unten abgewinkelte Halteorgane (72, 72′) mit Zapfen (79, 79′) sowie nach unten abgewinkelte Rasterorgane (80, 80′) mit Rasterzapfen (82, 82′ und 84, 84′) hat, wobei die einander gegenüberliegend angeordneten Rasterorgane (80, 80′) quer zur Längsrichtung des Steckerhalters federnd ausgebildet sind.

4. Baugruppeneinheit nach Anspruch 2, dadurch gekennzeichnet, dass zur Vermeidung von Fehleinschüben der Baugruppenträger (20) an der Rückseite der Leiterplatte (24) ein erstes Codierelement (90) und an dem Steckerhalter (70) ein zweites Codierelement (91) angeordnet ist.

5. Baugruppeneinheit nach den Ansprüchen 2 und 4, dadurch gekennzeichnet, dass in dem Boden (73) des Steckerhalters (70) zur steckbaren Befestigung der mit federnden Rasterzapfen (87, 87′) versehenen Codierelemente (85, 86) des zweiten Codierelements (91) mehrere im Abstand zueinander angeordnete Ausnehmungen (75, 76) vorgesehen sind.

## Claims

1. Modular unit comprising a supporting framework (10, 110) with two side walls (16, 17), two front and two rear mounting strips (11, 12, 13, 14) and at least one guide unit with one pair of guide rails (40, 55) secured in plug-in manner on the mounting strips, and a module carrier (20, 120) held in the supporting framework (10, 11) by at least one retaining element (25), which carrier is provided with a pin-plug element (21) for mutual electrical connection to a socket-plug element (21') arranged on the rear mounting strips (13, 14), characterised in that

a) the guide rails (40, 55), each with the front and rear end secured in plug-in manner on the mounting strips (11, 12, 13, 14), have on the rear end a retaining member (50) with pins (49) to hold the socket-plug element (21'), which retaining member can be inserted into recesses (57, 57'; 58, 58') appropriately provided on the socket-plug element,

b) to stabilise the modular unit there is arranged on the upper and lower portion of the carrier elements (23) a lug (35) which in the inserted state of the module carrier (20, 120) are in engagement with a groove (11', 12') correspondingly arranged in the front mounting strips (11, 12), and

c) the retaining element (25) provided for holding the individual module carriers (20, 120) is provided, on the side facing the front end (23') of the carrier element (23), with impact-resilient profiled parts (27, 27').

2. Modular unit with the supporting framework (10), which has a third mounting strip (15) between the two rear mounting strips (13, 14) for receiving, and the mutual electrical connection of, module carriers (20) of two-storey construction and provided with pin-plug elements (21, 22), characterised in that to hold two socket-plug elements (21', 22') correspondingly associated with the pin-plug elements (21, 22) there is provided a plug holder (70) which can be brought into engagement with the third mounting strip (15).

3. Modular unit according to claim 2, characterised in that the plug holder (70) which is U-shaped in cross sectional profile, has at both ends downwardly bent retaining members (72, 72') with pins (79, 79') and downwardly bent grid elements (80, 80') with grid pins (82, 82' and 84, 84'), wherein the grid elements (80, 80') arranged oppositely to each other are resiliently constructed transversely to the longitudinal direction of the plug holder.

4. Modular unit according to claim 2, characterised in that in order to avoid wrong insertions of the module carriers (20), a first coding element (90) is arranged on the rear side of the printed circuit board (24) and a second coding element (91) on the plug holder (70).

5. Modular unit according to claims 2 and 4, characterised in that in the base (73) of the plug holder (70) there is provided, for the plug-in fixing of the coding elements (85, 86) of the second coding element (91), provided with resilient grid pins (87, 87'), a plurality of recesses (75, 76) arranged at a distance from each other.

## Revendications

1. Unité modulaire se composant d'un châssis (10, 110) à deux parois latérales (16, 17), de deux longerons avant et deux longerons arrière (11, 12 ; 13, 14) et au moins une unité de guidage avec une paire de rails de guidage (40, 55) fixés par enfichage sur les longerons de support ainsi qu'un support de module (20, 120) tenu dans le châssis (10, 110) par au moins un organe de fixation (25), ce support comportant un élément de connecteur à broches (21) pour assurer la liaison électrique avec un élément femelle de connecteur (21') prévu sur les longerons de support arrière (13, 14), caractérisée en ce que :

a) les rails de guidage (40, 55) fixés par enfichage respectivement de l'extrémité avant et de l'extrémité arrière sur les longerons de support (11, 12 ; 13, 14) comportent pour la fixation de l'élément femelle de connecteur (21') à l'extrémité arrière, chaque fois un organe de fixation (50) muni d'un goujon (49) susceptible d'être introduit dans des cavités (57, 57' ; 58, 58') prévues de manière correspondante sur l'élément femelle de connecteur,

b) pour stabiliser l'unité modulaire sur la pièce supérieure et la pièce inférieure des éléments de support (23), il est prévu respectivement·un bec (35) qui, lorsque le support modulaire (20, 120) est mis en place, vient prendre dans une rainure (11', 12') correspondante des longerons de support avant (11, 12), et

c) l'organe de fixation (25) prévu pour la fixation des différents supports modulaires (20, 120) comporte du côté tourné vers la face frontale (23') de l'élément de support (23), des pièces profilées, élastiques aux chocs (27, 27').

2. Unité modulaire comportant un châssis (10) servant à recevoir et à relier électriquement des supports de module (20) à deux étages munis d'éléments de connecteur à broches (21, 22) et comportant un troisième longeron de support (15) entre les deux longerons de support arrière (13, 14), caractérisée en ce que pour la fixation de deux éléments femelles de connecteur (21, 22) correspondant aux éléments de connecteur à fiches (21', 22'), il est prévu un support de connecteur (70) susceptible d'être mis en prise par encliquetage avec le troisième longeron de support (15).

3. Unité modulaire selon la revendication 2, caractérisée en ce que le support de connecteur (70) à profil en section en U comporte aux deux extrémités des organes de fixation (72, 72') recourbés vers le bas et munis de goujons (79, 79') ainsi que d'organes d'encliquetage (80, 80'), recourbés vers le bas, munis de goujons d'encliquetage (82, 82' et 84, 84'), les organes d'encliquetage respectivement superposés (80, 80') étant élastiques transversalement à la direction longitudinale du support de connecteur.

4. Unité modulaire selon la revendication 2, caractérisée en ce que pour éviter les mises en place erronées des supports modulaires (20), la face arrière de la plaque de circuit (24) comporte un premier élément de codage (90) et le support de connecteur (70) comporte un second élément de codage (91).

5. Unité modulaire selon l'une des revendications 2 et 4, caractérisée en ce que pour la fixation par enfichage des éléments de codage (85, 86) munis de goujons d'encliquetage élastiques (87, 87') du second élément de codage (91), le fond (73) du support de connecteur (70) comporte plusieurs cavités (75, 76) prévues à une certaine distance l'une de l'autre.

FIG. 2

FIG. 1

0 105 151

FIG. 3

FIG. 4

FIG. 5

FIG. 6

FIG. 7